# EUROPÄISCHE PATENTSCHRIFT

(11) **EP 3 343 580 B1**
(45) Veröffentlichungstag und Bekanntmachung des Hinweises auf die Patenterteilung: **17.06.2020**
(21) Anmeldenummer: 17210689.0
(22) Anmeldetag: 27.12.2017
(51) Int. Cl.: H01H 3/02, H02B 1/044, H05K 3/30, H01H 13/86, H01H 1/58

(54) **HALTEMITTEL ZUR MONTAGE EINES BEFEHLSGERÄTS AN EINE LEITERPLATTE**
RETAINING MEANS FOR MOUNTING A COMMAND DEVICE ON A PRINTED CIRCUIT BOARD
MOYEN DE RETENUE PERMETTANT DE FIXER UN APPAREIL DE COMMANDE À UNE CARTE DE CIRCUIT IMPRIMÉ

(30) Priorität: 29.12.2016 DE 102016125825
(43) Veröffentlichungstag der Anmeldung: 04.07.2018
(73) Patentinhaber: Georg Schlegel GmbH & Co. KG, 88525 Duermentingen (DE)
(72) Erfinder: Schlegel, Eberhard, 88525 Dürmentingen (DE); Blank, Kurt, 88422 Bad Buchau (DE)
(74) Vertreter: Otten, Roth, Dobler & Partner mbB Patentanwälte

(56) Entgegenhaltungen:
- EP-A1- 2 704 273
- DE-A1- 3 511 359
- DE-A1- 4 101 388
- US-A- 5 099 094

## Beschreibung

### Stand der Technik

Befehlsgeräte bestehend aus einem Betätiger und einem Kontaktgeber sind allgemein bekannt.

Bei einer bekannten Ausgestaltung wird der Betätiger an einer Frontplatte angeordnet und ist mit dem Kontaktgeber verbunden, welcher hinter der Frontplatte, für einen Nutzer unsichtbar vorhanden ist. Der Kontaktgeber umfasst elektrische Kontakte, mit welchen er mit einem elektrischen System verbunden ist, z.B. mit elektrischen Kontakten einer Leiterplatte. In einer bekannten Ausbildung sind die elektrischen Kontakte des Kontaktgebers mit den Kontakten der Leiterplatte verlötet. Hierzu ist der Kontaktgeber mittels Montagemitteln fest mit der Leiterplatte verbunden.

US 5 099 094 A offenbart ein Haltemittel zur Montage eines Befehlsgeräts an eine Leiterplatte, gemäß dem Oberbegriff des Anspruchs 1.

Nachteilig daran ist die vergleichsweise aufwendige Montage des an der Frontplatte befestigten Betätigers mit den an der Leiterplatte vorhandenen Kontakten.

### Aufgabe und Vorteile der Erfindung

Aufgabe der vorliegenden Erfindung ist es, eine Vorrichtung bereitzustellen, welche eine vergleichsweise einfache Montage eines Befehlsgeräts der einleitend bezeichneten Art an einer Leiterplatte ermöglicht.

Diese Aufgabe wird durch die Merkmale des Anspruchs 1 gelöst.

In den abhängigen Ansprüchen sind vorteilhafte und zweckmäßige Ausführungsformen der Erfindung angegeben.

Die Erfindung geht von einem Haltemittel zur insbesondere werkzeuglosen Montage eines Befehlsgeräts und/oder Meldegeräts an eine Leiterplatte aus, wobei das Befehlsgerät einen Betätiger und einen Kontaktgeber umfasst.

Der Betätiger ist zum Beispiel als ein Taster und/oder ein Schalter ausgebildet und dazu vorgesehen, von einer Person, z.B. einem Nutzer, betätigt zu werden. Der Betätiger ist dazu vorgesehen mit dem Kontaktgeber zusammenzuwirken. Aufgrund der Betätigung wirkt der Betätiger derart mit dem Kontaktgeber zusammen, dass dieser eine elektrisch leitende Verbindung schaltet. Denkbar ist, dass das Befehlsgerät als ein Not-AusSchalter und/oder Not-Aus-Taster ausgebildet ist.

Der Kontaktgeber ist beispielsweise derart ausgestaltet, eine elektrisch leitende Verbindung schaltend und/oder tastend einzurichten, wobei wiederum der Kontaktgeber dazu vorgesehen ist, mit dem Betätiger zu wirken.

Der wesentliche Aspekt der Erfindung ist nun darin zu sehen, dass die Haltemittel ein Halteelement aufweisen, welches Anbringmittel besitzt, mittels welchen das Halteelement an die Leiterplatte ansteckbar ist und wobei das Halteelement Montagemittel umfasst, welche dazu ausgebildet sind, das Befehlsgerät, insbesondere den Betätiger und/oder den Kontaktgeber, lösbar festzuhalten.

Hierdurch ist eine vergleichsweise schnelle und einfache Montage oder Demontage der Haltemittel und insbesondere des Befehlsgeräts, z.B. des Betätigers und/oder des Kontaktgebers, an den Haltemittel und damit an der Leiterplatte bzw. der Leiterplatine realisiert.

Vorteilhafterweise ist das Halteelement dazu ausgebildet an die Leiterplatte angesteckt zu werden. Beispielsweise sind die Anbringmittel als Rastzapfen vorhanden, um in Aufnahmeöffnungen der Leiterplatte, insbesondere werkzeuglos, bspw. verliersicher einzurasten.

Denkbar ist auch, dass die Anbringmittel ein Innengewinde aufweisen oder als ein Gewindestift ausgebildet sind, mittels welchem das Halteelement an die Leiterplatte, beispielsweise mit Hilfe eines Werkzeugs, anschraubbar ist.

Die Montagemittel umfassen bevorzugterweise ein Rastelement, z.B. in Form eines hakenartigen Federelements, durch welches der Betätiger und/oder der Kontaktgeber mit dem Halteelement insbesondere lösbar verbindbar, z.B. verrastbar ist.

Auch ist es von Vorteil, dass das Halteelement eine Einstecköffnung aufweist, in welche der Kontaktgeber des Befehlsgeräts einsetzbar und/oder einsteckbar ist. Beispielsweise ist hierdurch eine elektrisch leitende Verbindung des Kontaktgebers mit der Leiterplatte herstellbar.

Denkbar ist allerdings auch, dass das Halteelement derart ausgebildet ist, sodass der Kontaktgeber auf das Halteelement aufsteckbar ist, wobei der Kontaktgeber im aufgesteckten Zustand das Halteelement z.B. seitlich, zumindest an dessen Außenseite, umschließt.

In einer vorteilhaften Ausbildung der Haltemittel weist das Halteelement eine Einstecköffnung auf, in welche der Betätiger des Befehlsgeräts einsetzbar ist. Beispielsweise ist der Betätiger in die Einstecköffnung einsteckbar und/oder einschiebbar ist. Vorteilhafterweise umschließt oder umgreift das Halteelement mit der Einstecköffnung das Befehls- und/oder Meldegerät, z.B. den Betätiger und/oder z.B. den Kontaktgeber, im eingesetzten Zustand.

Denkbar ist auch, dass der Kontaktgeber in die Einstecköffnung einsetzbar ist und der Betatiger auf die Einstecköffnung aufschiebbar, z.B. aufrastbar ist, sodass der Betätiger beispielsweise das Haltelement und/oder den Kontaktgeber im Bereich der Einstecköffnung zumindest oben und/oder seitlich umschließt.

Die Einstecköffnung ist vorteilhafterweise zylinderförmig oder ringartig ausgebildet. Denkbar ist allerdings auch, dass die Einstecköffnung eckig, z.B. rechteckig bzw. mehreckig vorhanden ist.

Überdies von Vorteil ist, dass das Halteelement Anbringmittel in Form von zwei Haltestellen aufweist, wobei die Haltestellen miteinander verbunden und für eine Fixierung an der Leiterplatte ausgebildet sind. Hierdurch ist eine Montage verbessert. Ebenfalls vorteilhaft ist hierdurch eine Haltekraft der Haltemittel an der Leiterplatte erhöht.

Vorteilhafterweise umfasst das Halteelement mehrere Haltestellen, z.B. drei, insbesondere vier Haltestellen. Beispielsweise sind die Haltestellen über die Einstecköffnung miteinander verbunden. Beispielsweise ist das Halteelement plattenartig vorhanden und weist z.B. in seiner Mitte die insbesondere ringartige Einstecköffnung auf. Vorteilhafterweise umfasst die Leiterplatte zwei, zu den Haltestellen korrespondierende Halteorgane. Hierdurch ist eine vergleichsweise genaue Ausrichtung der Haltemittel an der Leiterplatte und damit z.B. eine vergleichsweise genaue Ausrichtung des Befehlsgeräts an der Leiterplatte realisiert. Die Haltestellen sind beispielsweise als Rastzapfen vorhanden und die Halteorgane als Rastöffnungen, z.B. als Bohrungen, insbesondere Durchgangbohrungen an der Leiterplatte. Bevorzugterweise sind die Rastzapfen in die Rastöffnungen einsteckbar oder einschiebbar. Beispielsweise verrasten die Rastzapfen im eingesetzten Zustand an den Rastöffnungen mit der Leiterplatte, insbesondere mit den Rastöffnungen. Hierdurch sind die Haltemittel z.B. positionsgenau an der Leiterplatte fixiert.

Denkbar ist auch, dass die Haltestellen als Gewindestifte vorhanden sind. Z.B. umfassen die Gewindestifte ein Außenund/oder ein Innengewinde und sind beispielsweise im eingesetzten Zustand an den Halteorganen mittels einer Mutter oder einer Schraube an der Leiterplatte fixierbar.

Gemäß der Erfindung ist vorgesehen, dass die Montagemittel einen Schließmechanismus umfassen, welcher derart ausgestaltet ist, im angeordneten Zustand des Befehlsgeräts an den Haltemittel den Kontaktgeber mit dem Betätiger lösbar zu verbinden.

Beispielsweise umschließt der Betätiger den Kontaktgeber im angeordneten Zustand, sodass der Kontaktgeber zwischen der Leiterplatte und dem Betätiger vorhanden ist. Ist der Betätiger in diesem Fall mittels des Schließmechanismus lösbar mit den Haltemitteln verbunden, so ist der Kontaktgeber ebenfalls mit dem Betätiger verbunden.

Vorteilhafterweise ist der Betätiger durch den Schließmechanismus positionsfest, insbesondere relativ zur Leiterplatte, an den Haltemitteln z.B. lösbar fixierbar. Beispielsweise ist der Schließmechanismus werkzeuglos betätigbar ausgebildet.

Gemäß der Erfindung ist ebenfalls vorgesehen, dass der Schließmechanismus ein Riegelelement umfasst, wobei im angeordneten Zustand des Befehlsgeräts durch das Riegelelement, insbesondere durch einen Drehbewegung des Riegelelements, das Befehlsgerät mit den Haltemitteln, insbesondere mit dem Haltelement, lösbar verbindbar ist.

Das Riegelelement ist vorteilhafterweise derart vorhanden, dass das Befehlsgerät durch eine Schwenk- und/oder Drehbewegung des Riegelelements in einer Ebene parallel zu einer Leiterplattenoberfläche oder zu einer Oberfläche einer Einbauplatte mit den Haltemitteln lösbar verbindbar ist.

An der Einbauplatte ist vorteilhafterweise der Betätiger, insbesondere positionsfest, montiert. Die Einbauplatte dient beispielsweise als Blendenelement und/oder als Abdeckung für eine darunter liegende Elektronik, z.B. die Leiterplatte und/oder den Kontaktgeber.

Das Riegelelement greift in einer Schließbewegung vorteilhafterweise sperrend in eine Aussparung des Betätigers ein. Hierdurch ist bevorzugterweise eine Position des Betätigers relativ zu den Haltemitteln, insbesondere zur Leiterplatte festgelegt.

Ebenfalls von Vorteil ist, dass der Schließmechanismus derart vorhanden ist, dass die Drehbewegung des Riegelelements durch einen Monteur, beispielsweise mit Hilfe eines Werkzeugs, ausgehend von einer dem Halteelement gegenüberliegenden Seite der Leiterplatte auslösbar ist.

Vorteilhafterweise greift der Schließmechanismus durch eine Öffnung der Leiterplatte hindurch. Denkbar ist auch, dass der Schließmechanismus durch eine Öffnung der Leiterplatte bedienbar ist.

In einer vorteilhaften Ausführung der Haltemittel umfassen die Haltemittel ein Distanzhalteelement, um im angeordneten Zustand des Befehlsgeräts an den Haltemitteln, insbesondere an der Leiterplatte, und an einer Einbauplatte einen Abstand zwischen einer Unterseite des Halteelements, insbesondere einer Leiterplattenoberfläche, und einer Oberseite der Einbauplatte festzulegen.

Im angeordneten Zustand des Befehlsgeräts und der Haltemittel an der Leiterplatte und der Einbauplatte ist ein Abstand der Oberseite der Einbauplatte, welche den Haltemitteln abgewandt vorhanden ist, zu einer Oberseite der Leiterplatte, an welcher die Haltemittel und der Kontaktgeber vorhanden sind, unabhängig von einer Dicke der Einbauplatte immer gleich. Dieser Abstand ist vorteilhafterweise durch die Ausbildung des Distanzhalteelements definiert.

Das Distanzhalteelement kann beispielsweise an der Einstecköffnung und/oder am Halteelement ausgebildet sind. Z.B. ist das Distanzhalteelement als ein Anschlagelement ausgebildet. Wobei der Betätiger im angeordneten Zustand am Anschlagelement anstößt, sodass der Abstand zwischen der Oberseite der Leiterplatte und der Oberseite der Einbauplatte festgelegt ist.

Des Weiteren ist es bevorzugt, dass die Montagemittel Gewindemittel aufweisen, mittels welchen der Betätiger am Halteelement befestigbar ist.

Zum Beispiel besitzt der Betätiger Gewindemittel, sodass der Betätiger an die Montagemittel anschraubbar oder aufschraubbar ist. Hierdurch sind im angeordneten Zustand beispielsweise die Haltemittel, der Kontaktgeber und der Betätiger miteinander verbindbar. Vorteilhafterweise sind die Montagemittel an der Einstecköffnung ausgebildet. Beispielsweise umfasst die ringartige Einstecköffnung ein Innen- und/oder ein Außengewinde.

Überdies vorteilhaft ist, dass das Befehlsgerät ein Haltemittel nach einem der vorangegangenen Ansprüche umfasst.

Bevorzugterweise ist das Befehlsgerät dazu ausgestaltet, an einem Haltemittel angeordnet zu werden, sodass das Befehlsgerät mit dem Haltemittel insbesondere zusammen an einer Leiterplatte und/oder einer Einbauplatte montierbar ist.

Vorteilhafterweise umfasst der Betätiger und/oder der Kontaktgeber ein Schließelement, welches derart ausgestaltet ist, dass der Schließmechanismus der Haltemittel mit dem Schließelement im montierten Zustand wechselwirkt.

Das Schließelement ist z.B. als eine Öffnung ausgebildet in welche das Riegelelement des Schließmechanismus im montierten eingreift. Vorteilhafterweise sind mehrere Schließelemente vorhanden. Beispielsweise sind die Schließelemente gleichmäßig verteilt am Betätiger und/oder am Kontaktgeber vorhanden.

Auch erweist es sich als vorteilhaft, dass der Betätiger getrennt vom Kontaktgeber an der Einbauplatte befestigbar ist und der Kontaktgeber getrennt vom Betätiger am Halteelement anordenbar ist, wobei das Halteelement an der Leiterplatte angebracht ist, sodass der Betätiger zusammen mit der Einbauplatte am Kontaktgeber und dem Halteelement, insbesondere der Leiterplatte, montierbar ist.

Vorteilhafterweise ist der Betätiger im montierten Zustand an der Leiterplatte durch den Schließmechanismus des Halteelements mit dem Halteelement verriegelbar vorhanden.

Auch ist es bevorzugt, dass die Haltemittel und der Kontaktgeber einstückig vorhanden sind.

### Beschreibung des Ausführungsbeispiels

Mehrere Ausführungsbeispiele werden anhand der nachstehenden schematischen Zeichnungen unter Angabe weitere Einzelheiten und Vorteile näher erläutert.

Es zeigen:
- Figur 1:: eine perspektivische Ansicht von schräg oben auf drei erfindungsgemäße Haltemittel im angeordneten Zustand an einem Befehlsgerät, einer Leiterplatte und einer Einbauplatte,
- Figur 2:: eine perspektivische Explosionsdarstellung der Anordnung aus Figur 1,
- Figuren 3 und 4:: eine Draufsicht, sowie eine perspektivische Ansicht von schräg oben auf eine weitere Ausbildung des Haltemittels, welches einstückig mit einem Kontaktgeber vorhanden ist,
- Figur 5:: eine seitliche Ansicht auf eine weitere Variante des Haltemittels im angeordneten Zustand am Befehlsgerät, der Leiterplatte und der Einbauplatte und
- Figur 6:: eine seitliche Ansicht auf eine vierte Variante des Haltemittels im angeordneten Zustand am Befehlsgerät, der Leiterplatte und der Einbauplatte.

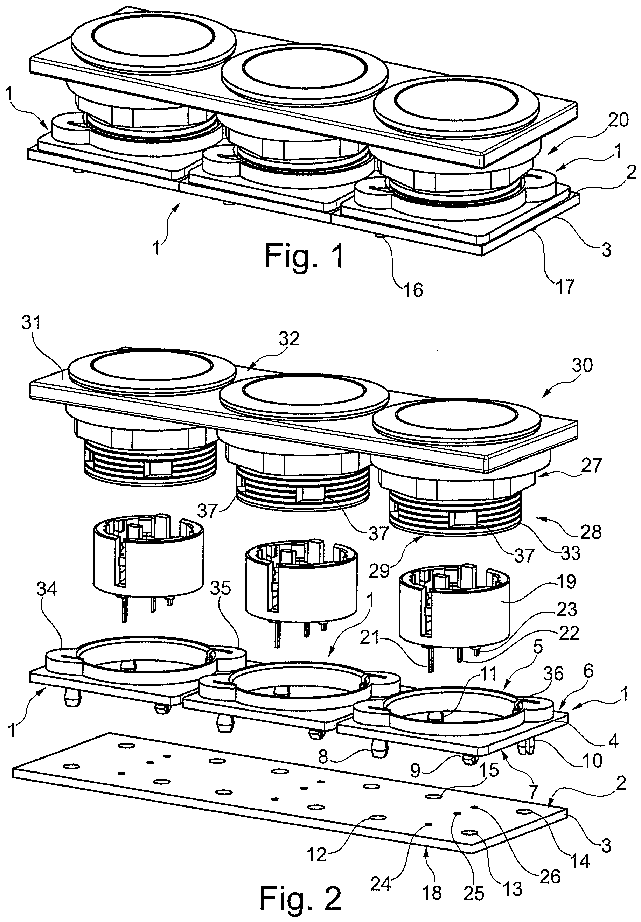

Ein erfindungsgemäßes Haltemittel 1 ist im angeordneten Zustand an einer Oberseite 2 einer Leiterplatine 3 befestigt (Figur 1).

Das Haltemittel 1 umfasst ein plattenförmiges Halteelement 4, welches eine Einstecköffung 5 aufweist. Die Einstecköffnung 5 ist ringförmig bzw. zylindermantelartig vorhanden und vorteilhafterweise erhaben bzw. abstehend von einer Oberseite 6 des Halteelements 4 am Halteelement 4 vorhanden (Figur 2).

An einer Unterseite 7 des Halteelements 4, welche gegenüberliegend zur Oberseite 6 vorhanden ist, sind insbesondere vier Steckzapfen 8 - 11 abstehend vorhanden. Die Steckzapfen 8 bis 11 sind vorteilhafterweise derart ausgebildet, dass sie in Stecköffnungen 12 bis 15 der Leiterplatte 3 im angeordneten Zustand des Haltemittels 1 an der Leiterplatte 3 eingreifen und das Haltemittel 1 vorteilhafterweise an der Leiterplatte 3 fixieren. Hierzu sind die Steckzapfen 8 bis 11 z.B. elastisch ausgebildet und besitzen z.B. einen Schlitz entlang ihrer Längsachse und weisen insbesondere einen Außendurchmesser auf, welcher größer ist, als ein Durchmesser der Stecköffnungen 12 bis 15. Denkbar ist auch, das die Steckzapfen 8 bis 11 durch Fixierorgane 16, 17, z.B. durch eine Schraube oder eine Mutter, welche beispielsweise mittels eines Werkzeugs betätigbar sind, auf einer Unterseite 18 der Leiterplatte 3 fixierbar ausgebildet sind.

Im angeordneten Zustand des Haltemittels 1 liegt das Halteelement 4 vorteilhafterweise mit seiner Unterseite 7 auf der Oberseite 2 der Leiterplatte 3 auf.

Ein Kontaktgeber 19 eines Befehlsgeräts 20 ist vorteilhafterweise zylinderförmig ausgebildet, sodass der Kontaktgeber 19 in die Einstecköffnung 5 des Halteelements 4 einsetzbar, bzw. einsteckbar ist. Hierdurch ist ein elektrischer Kontakt zwischen elektrischen Kontaktelementen 21 - 23 des Kontaktgebers und elektrischen Kontaktstellen 24 - 26 der Leiterplatte 3 realisierbar. Z.B. werden die Kontaktelemente 21 - 23 mit den Kontaktstellen 24 - 26 ausgehend von der Unterseite 18 der Leiterplatte 3 miteinander verlötet.

Ein Betätiger 27 ist an einem unteren Ende 28 vorteilhafterweise zylindermantelförmig bzw. ringartig vorhanden. Beispielsweise besitzt der Betätiger 27 an seinem unteren Ende 28 eine Öffnung 29, welche einen Innendurchmesser aufweist, welcher größer ist, als ein Außendurchmesser des Kontaktgebers 19, sodass der Betätiger 27 über den Kontaktgeber 19 gestülpt bzw. geschoben werden kann. Hierdurch ist es vorstellbar, dass der Betätiger 27 den Kontakgeber 19 insbesondere vollständig in seinem Inneren, z.B. in der Öffnung 29 aufnimmt, insbesondere im zusammengesetzten Zustand des Befehlsgeräts 20.

Weiterhin vorteilhaft besitzt der Betätiger 27 einen Zylindermantel 33, welcher die Öffnung 29 umfasst und einen Außendurchmesser ausweist, welcher kleiner ist, als ein Innendurchmesser der Einstecköffnung 5 des Haltelements 4. Hierdurch ist der Betätiger 27, insbesondere der Zylindermantel 33 im angeordneten Zustand zwischen der Einstecköffnung 5 und dem Kontaktgeber 19 an der Leiterplatte 3 positionierbar.

Der Betätiger 27 ist an einem, dem unterem Ende 28 gegenüberliegenden Ende 30 an einer Einbauplatte 31 in herkömmlicher Weise befestigbar. Hierbei ist der Betätiger 27 derart an der Einbauplatte 31 montierbar, sodass ein Nutzer den Betätiger ausgehend von einer Oberseite 32 der Einbauplatte 31 betätigen kann.

Vorteilhafterweise ist in einem ersten Montageschritt zunächst der Betätiger 27 an der Einbauplatte 31 befestigbar und das Halteelement 4 mit dem Kontaktgeber 19 an der Leiterplatte 2, sodass in einem darauf folgenden Montageschritt die beiden montierten Bauteile vergleichsweise einfach aneinander fügbar, insbesondere aneinander oder aufeinander steckbar sind. Hierdurch ist eine Montage vereinfacht.

Das Haltelement 4 umfasst beispielsweise einen, insbesondere zwei Schließmechanismen 34, 35 mittels welchen der Betätiger 27 im angeordneten Zustand am Halteelement 4 fixierbar ist. Ein Schließmechanimus 34, 35 umfasst z.B. ein hakenartiges Riegelelement 36, welches im angeordneten Zustand des Betätigers 27 in eine Halteöffnung 37 des Betätigers 27 lösbar einschwenkbar ist. Die Halteöffnung 37 ist beispielsweise am Zylindermantel 33 angeordnet. Bevorzugterweise umfasst der Betätiger 27 mehrere Halteöffnungen 37, welche bevorzugt in einer Ebenen z.B. gleichmäßig verteilt am Zylindermantel 33 vorhanden sind.

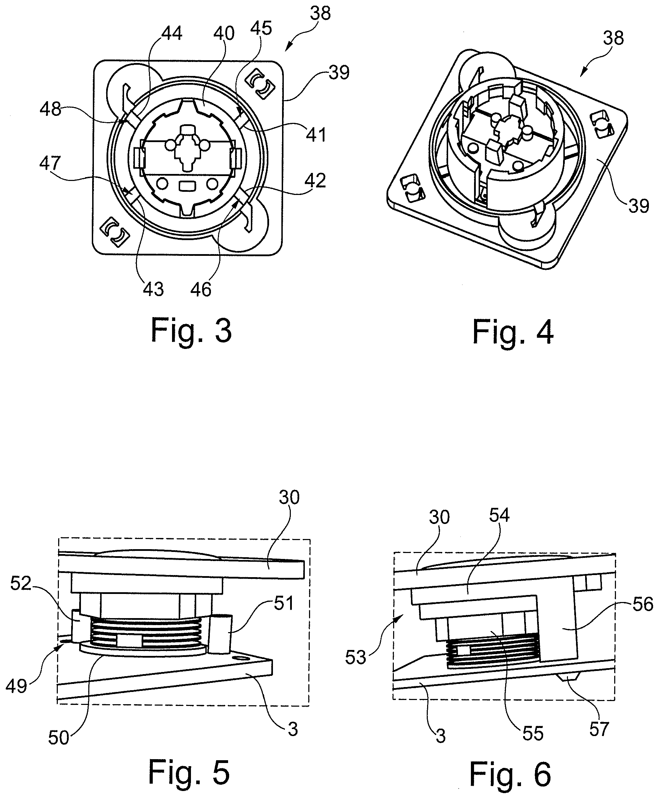

In den Figuren 3 und 4 ist eine Variante eines Kontaktgebers 38 gezeigt, an welchem ein Halteelement 39 einstückig mit dem Kontaktgeber 38 vorhanden ist. Beispielsweise ist ein zylinderförmiges Gehäuse 40 des Kontaktgebers 38 mittels Stege 41 - 44 mit dem Halteelement 39 verbunden. Beispielsweise mittels eines Kunststoff-Spritzguß-Prozesses.

Die Stege 41 - 44 des Kontaktgebers 38, insbesondere die Oberseiten 45 - 48 der Stege 41 - 44 besitzen beispielsweise die Funktion eines Anschlags für einen anordenbaren Betätiger 27. Hierdurch ist ein Abstand der Oberseite 2 der Leiterplatte 3 zu der Oberseite 31 der Einbauplatte 30 im angeordneten Zustand eines Befehlsgeräts bestehend aus dem Kontaktgeber 38 und dem Betätiger 27 an der Leiterplatte 3 und der Einbauplatte 30 vorgebbar.

In Figur 5 ist eine weitere Variante eines Haltemittels 49 gezeigt. Das Haltemittel 49 besitzt ein Halteelement 50, welches statt Steckzapfen, die in die Leiterplatte 3 eingreifen, Befestigungshülsen 51, 52 aufweist, welche über die Stecköffnungen 12 - 15 der Leiterplatte 3 positionierbar ausgebildet sind. Hierzu greifen die Befestigungshülsen 51, 52 beispielsweise in die Stecköffnungen 12 - 15 ein, verrasten aber nicht. Die Befestigungshülsen 51, 52, sind hohl ausgebildet und besitzen im Inneren ein Innengewinde. In das Innengewinde greift ausgehend von der Unterseite 18 der Leiterplatte 3 durch die Leiterplatte 3 eine Schraube, welche in das Innengewinde der Befestigungshülse 51, 52 eingreift und hierdurch das Haltemittel 49 an der Leiterplatte 3 fixiert.

Eine weitere Ausführung eines Haltemittels 53 ist in Figur 6 gezeigt. Das Haltemittel 53 umfasst entgegen der vorherig gezeigten Varianten ein Halteelement 54, welches an der Einbauplatte zusammen mit dem Betätiger 27 befestigbar ist. Der Betätiger 27 ist hierbei z.B. mittels einer Mutter 55 am Halteelement 54 lösbar festgelegt. Des Weiteren ist am Halteelement 54 ein Zapfen 56 vorhanden, mittels welchem das Halteelement 54 und somit der Betätiger 27 an der Leiterplatte 3 befestigbar ist. Der Zapfen 56 hat vorteilhafterweise zusätzlich die Funktion eines Distanzhalteelements, um beispielsweise einen Abstand zwischen der Oberseite 31 der Einbauplatte 30 und der Oberseite 2 der Leiterplatte 3 festzulegen. Der Zapfen 56 ist beispielsweise mittels einer Schraube 57 an der Leiterplatte 3 fixierbar.

### Bezugszeichenliste

| | | | |
|---|---|---|---|
| 1 | Haltemittel | 31 | Einbauplatte |
| 2 | Oberseite | 32 | Oberseite |
| 3 | Leiterplatte | 33 | Zylindermantel |
| 4 | Halteelement | 34, 35 | Schließmechanismus |
| 5 | Einstecköffnung | 36 | Riegelelement |
| 6 | Oberseite | 37 | Halteöffnung |
| 7 | Unterseite | 38 | Kontaktgeber |
| 8 - 11 | Steckzapfen | 39 | Halteelement |
| 12 - 15 | Stecköffnung | 40 | Gehäuse |
| 16, 17 | Fixierorgan | 41 - 44 | Steg |
| 18 | Unterseite | 45 - 48 | Oberseite |
| 19 | Kontaktgeber | 49 | Haltemittel |
| 20 | Befehlsgerät | 50 | Halteelement |
| 21 - 23 | Kontaktelement | 51, 52 | Befestigungshülse |
| 24 - 26 | Kontaktstelle | 53 | Haltemittel |
| 27 | Betätiger | 54 | Halteelement |
| 28 | Ende | 55 | Mutter |
| 29 | Öffnung | 56 | Zapfen |
| 30 | Ende | 57 | Schraube |

## Patentansprüche

1. Haltemittel (1, 49, 53) zur Montage eines Befehlsgeräts (20) an eine Leiterplatte (3), wobei das Befehlsgerät (20) einen Betätiger (27) und einen Kontaktgeber (19) umfasst, wobei die Haltemittel (1, 49, 53) ein Halteelement (4, 39, 50, 54) aufweisen, welches Anbringmittel besitzt, mittels welchen das Halteelement (4, 39, 50, 54) an die Leiterplatte (3) ansteckbar ist und wobei das Halteelement (4, 39, 50, 54) Montagemittel umfasst, welche dazu ausgebildet sind, das Befehlsgerät (20) lösbar festzuhalten, **dadurch gekennzeichnet, dass** die Montagemittel einen Schließmechanismus (34, 35) umfassen, welcher derart ausgestaltet ist, im angeordneten Zustand des Befehlsgeräts (20) an den Haltemittel (1, 49, 53) den Kontaktgeber (19) mit dem Betätiger (27) lösbar zu verbinden, wobei der Schließmechanismus (34, 35) ein Riegelelement (36) umfasst, wobei im angeordneten Zustand des Befehlsgeräts (20) durch das Riegelelement (36), insbesondere durch einen Drehbewegung des Riegelelements (36), das Befehlsgerät (20) mit den Haltemitteln (1, 49, 53), insbesondere mit dem Haltelement (4, 39, 50, 54), lösbar verbindbar ist.

2. Haltemittel (1, 49, 53) nach dem Anspruch 1, **dadurch gekennzeichnet, dass** das Halteelement (4, 39, 50, 54) eine Einstecköffnung (5) aufweist, in welche der Kontaktgeber (19) des Befehlsgeräts (20) einsetzbar ist.

3. Haltemittel (1, 49, 53) nach einem der vorangegangenen Ansprüche, **dadurch gekennzeichnet, dass** das Halteelement (4, 39, 50, 54) eine Einstecköffnung (5) aufweist, in welche der Betätiger (27) des Befehlsgeräts (20) einsetzbar ist.

4. Haltemittel (1, 49, 53) nach einem der vorangegangenen Ansprüche, **dadurch gekennzeichnet, dass** das Halteelement (4, 39, 50, 54) Anbringmittel (8 - 11) in Form von zwei Haltestellen (8 - 11) aufweist, wobei die Haltestellen miteinander verbunden und für eine Fixierung an der Leiterplatte (3) ausgebildet sind.

5. Haltemittel (1, 49, 53) nach einem der vorangegangenen Ansprüche, **dadurch gekennzeichnet, dass** der Schließmechanismus (34, 35) derart vorhanden ist, dass die Drehbewegung des Riegelelements (36) durch einen Monteur ausgehend von einer dem Halteelement (4, 39, 50, 54) gegenüberliegenden Seite (18) der Leiterplatte (3) auslösbar ist.

6. Haltemittel (1, 49, 53) nach einem der vorangegangenen Ansprüche, **dadurch gekennzeichnet, dass** die Haltemittel (1, 49, 53) ein Distanzhalteelement umfassen, um im angeordneten Zustand des Befehlsgeräts (20) an den Haltemitteln (1, 49, 53) und an einer Einbauplatte (31) einen Abstand zwischen einer Unterseite (7) des Halteelements (4, 39, 50, 54), insbesondere einer Leiterplattenoberfläche (2), und einer Oberseite (32) der Einbauplatte (31) festzulegen.

7. Haltemittel (1, 49, 53) nach einem der vorangegangenen Ansprüche, **dadurch gekennzeichnet, dass** die Montagemittel Gewindemittel aufweisen, mittels welcher der Betätiger (27) am Halteelement (4, 39, 50, 54) befestigbar ist.

8. Befehlsgerät (20) bestehend aus einem Betätiger (27) und einem Kontaktgeber (19), **dadurch gekennzeichnet, dass** das Befehlsgerät (20) ein Haltemittel (1, 49, 53) nach einem der vorangegangenen Ansprüche umfasst.

9. Befehlsgerät (20) nach dem vorangegangen Anspruch 8, **dadurch gekennzeichnet, dass** der Betätiger (27) getrennt vom Kontaktgeber (19) an der Einbauplatte (31) befestigbar ist und der Kontaktgeber (19) getrennt vom Betätiger (27) am Halteelement (4, 39, 50, 54) anordenbar ist, wobei das Halteelement (4, 39, 50, 54) an der Leiterplatte (3) angebracht ist, sodass der Betätiger (27) zusammen mit der Einbauplatte (31) am Kontaktgeber (19) und dem Halteelement (4, 39, 50, 54), insbesondere der Leiterplatte (3), montierbar ist.

10. Befehlsgerät (20) nach einem der vorangegangen Ansprüche 8 oder 9, **dadurch gekennzeichnet, dass** die Haltemittel (1, 49, 53) und der Kontaktgeber (19) einstückig vorhanden sind.

## Claims

1. Holding means (1, 49, 53) for mounting a control device (20) on a circuit board (3), wherein the control device (20) comprises an actuator (27) and a contactor (19), wherein the holding means (1, 49, 53) have a holding element (4, 39, 50, 54) that has attachment means by way of which the holding element (4, 39, 50, 54) is able to be plugged onto the circuit board (3) and wherein the holding element (4, 39, 50, 54) comprises mounting means that are designed to releasably hold the control device (20), **characterized in that** the mounting means comprise a clasp mechanism (34, 35) that is designed so as to releasably connect the contactor (19) to the actuator (27) in the state in which the control device (20) is installed on the holding means (1, 49, 53), wherein the clasp mechanism (34, 35) comprises a bar element (36), wherein the control device (20) is able to be connected releasably to the holding means (1, 49, 53), in particular to the holding element (4, 39, 50, 54), by the bar element (36), in particular by a rotational movement of the bar element (36), in the installed state of the control device (20).

2. Holding means (1, 49, 53) according to Claim 1, **characterized in that** the holding element (4, 39, 50, 54) has a plug-in opening (5) into which the contactor (19) of the control device (20) is able to be inserted.

3. Holding means (1, 49, 53) according to either of the preceding claims, **characterized in that** the holding element (4, 39, 50, 54) has a plug-in opening (5) into which the actuator (27) of the control device (20) is able to be inserted.

4. Holding means (1, 49, 53) according to one of the preceding claims, **characterized in that** the holding element (4, 39, 50, 54) has attachment means (8 - 11) in the form of two holding points (8 - 11), wherein the holding points are connected to one another and are designed to be fastened to the circuit board (3).

5. Holding means (1, 49, 53) according to one of the preceding claims, **characterized in that** the clasp mechanism (34, 35) is present such that the rotational movement of the bar element (36) is able to be triggered by an engineer from a side (18), opposite the holding element (4, 39, 50, 54), of the circuit board (3).

6. Holding means (1, 49, 53) according to one of the preceding claims, **characterized in that** the holding means (1, 49, 53) comprise a spacer element in order to define a distance between a bottom side (7) of the holding element (4, 39, 50, 54), in particular a circuit board surface (2), and a top side (32) of a mounting plate (31) in the state in which the control device (20) is installed on the holding means (1, 49, 53) and on the mounting plate (31).

7. Holding means (1, 49, 53) according to one of the preceding claims, **characterized in that** the mounting means have threaded means by way of which the actuator (27) is able to be fastened to the holding element (4, 39, 50, 54).

8. Control device (20) consisting of an actuator (27) and a contactor (19), **characterized in that** the control device (20) comprises a holding means (1, 49, 53) according to one of the preceding claims.

9. Control device (20) according to preceding Claim 8, **characterized in that** the actuator (27) is able to be fastened to the mounting plate (31) separately from the contactor (19) and the contactor (19) is able to be installed on the holding element (4, 39, 50, 54) separately from the actuator (27), wherein the holding element (4, 39, 50, 54) is attached to the circuit board (3) such that the actuator (27) is able to be mounted together with the mounting plate (31) on the contactor (19) and the holding element (4, 39, 50, 54), in particular the circuit board (3).

10. Control device (20) according to either of preceding Claims 8 and 9, **characterized in that** the holding means (1, 49, 53) and the contactor (19) are present as one part.

## Revendications

1. Moyens de maintien (1, 49, 53) destinés au montage d'un appareil d'instruction (20) sur un circuit imprimé (3), l'appareil d'instruction (20) comprenant un actionneur (27) et un transmetteur de contact (19), les moyens de maintien (1, 49, 53) présentant un élément de maintien (4, 39, 50, 54) qui possède des moyens de mise en place à l'aide desquels l'élément de maintien (4, 39, 50, 54) peut être attaché au circuit imprimé (3) et l'élément de maintien (4, 39, 50, 54) comportant des moyens de montage qui sont configurés pour retenir l'appareil d'instruction (20) de manière détachable, **caractérisés en ce que** les moyens de montage comportent un mécanisme de fermeture (34, 35) qui est configuré de manière à relier de manière détachable le transmetteur de contact (19) à l'actionneur (27) lorsque l'appareil d'instruction (20) est disposé sur les moyens de maintien (1, 49, 53), le mécanisme de fermeture (34, 35) comportant un élément formant verrou (36), l'appareil d'instruction (20), dans l'état monté de l'appareil d'instruction (20), pouvant être relié de manière détachable aux moyens de maintien (1, 49, 53), notamment à l'élément de maintien (4, 39, 50, 54), par l'élément formant verrou (36), notamment par un mouvement de rotation de l'élément formant verrou (36).

2. Moyens de maintien (1, 49, 53) selon la revendication 1, **caractérisés en ce que** l'élément de maintien (4, 39, 50, 54) possède une ouverture d'insertion (5) dans laquelle peut être introduit le transmetteur de contact (19) de l'appareil d'instruction (20).

3. Moyens de maintien (1, 49, 53) selon l'une des revendications précédentes, **caractérisés en ce que** l'élément de maintien (4, 39, 50, 54) possède une ouverture d'insertion (5) dans laquelle peut être introduit l'actionneur (27) de l'appareil d'instruction (20).

4. Moyens de maintien (1, 49, 53) selon l'une des revendications précédentes, **caractérisés en ce que** l'élément de maintien (4, 39, 50, 54) possède des moyens de mise en place (8 - 11) sous la forme de deux points de maintien (8 - 11), les points de maintien étant reliés entre eux et étant configurés pour un calage contre le circuit imprimé (3).

5. Moyens de maintien (1, 49, 53) selon l'une des revendications précédentes, **caractérisés en ce que** le mécanisme de fermeture (34, 35) est présent de telle sorte que le mouvement de rotation de l'élément formant verrou (36) peut être déclenché par un monteur à partir d'un côté (18) du circuit imprimé (3) opposé à l'élément de maintien (4, 39, 50, 54).

6. Moyens de maintien (1, 49, 53) selon l'une des revendications précédentes, **caractérisés en ce que** les moyens de maintien (1, 49, 53) comprennent un élément entretoise afin de, dans l'état monté de l'appareil d'instruction (20) aux moyens de maintien (1, 49, 53) et à une plaque d'installation (31), fixer un écart entre un côté inférieur (7) de l'élément de maintien (4, 39, 50, 54), notamment une surface de circuit imprimé (2), et un côté supérieur (32) de la plaque d'installation (31).

7. Moyens de maintien (1, 49, 53) selon l'une des revendications précédentes, **caractérisés en ce que** les moyens de montage possèdent des moyens filetés au moyen desquels l'actionneur (27) peut être fixé à l'élément de maintien (4, 39, 50, 54).

8. Appareil d'instruction (20) composé d'un actionneur (27) et d'un transmetteur de contact (19), **caractérisé en ce que** l'appareil d'instruction (20) comporte un moyen de maintien (1, 49, 53) selon l'une des revendications précédentes.

9. Appareil d'instruction (20) selon la revendication précédente 8, **caractérisé en ce que** l'actionneur (27) peut être fixé à la plaque d'installation (31) séparément du transmetteur de contact (19) et le transmetteur de contact (19) peut être disposé sur l'élément de maintien (4, 39, 50, 54) séparément de l'actionneur (27), l'élément de maintien (4, 39, 50, 54) étant apposé sur le circuit imprimé (3) de sorte que l'actionneur (27) peut être monté au transmetteur de contact (19) et à l'élément de maintien (4, 39, 50, 54), notamment au circuit imprimé (3), conjointement avec la plaque d'installation (31).

10. Appareil d'instruction (20) selon l'une des revendications précédentes 8 ou 9, **caractérisé en ce que** les moyens de maintien (1, 49, 53) et le transmetteur de contact (19) sont présents d'un seul tenant.
